# EUROPEAN PATENT SPECIFICATION

(11) **EP 4 490 776 B1**
(45) Date of publication and mention of the grant of the patent: **24.09.2025**
(21) Application number: 23732198.9
(22) Date of filing: 22.05.2023
(51) Int. Cl.: H01L 23/00, H01L 23/498, H01L 23/538

(54) **FLEXIBLE ELECTRONIC DEVICES INCLUDING INTERNALLY ROUTED CHANNELS**
FLEXIBLE ELEKTRONISCHE VORRICHTUNGEN MIT INTERN GELEITETEN KANÄLEN
DISPOSITIFS ÉLECTRONIQUES FLEXIBLES COMPRENANT DES CANAUX À ROUTAGE INTERNE

(30) Priority: 26.05.2022 US 202263365402 P
(43) Date of publication of application: 15.01.2025
(73) Proprietor: 3M Innovative Properties Company, Saint Paul, Minnesota 55133-3427 (US)
(72) Inventor: SHAH, Saagar A., Saint Paul, Minnesota 55133-3427 (US); PEKUROVSKY, Mikhail L., Saint Paul, Minnesota 55133-3427 (US); DODDS, Shawn C., Saint Paul, Minnesota 55133-3427 (US); GABRIEL, Nicholas T., Saint Paul, Minnesota 55133-3427 (US); NICCUM, Kayla C., Saint Paul, Minnesota 55133-3427 (US); MEYERS, Kara A., Saint Paul, Minnesota 55133-3427 (US); PEKUROVSKY, Lyudmila A., Saint Paul, Minnesota 55133-3427 (US); SWANSON, Ronald P., Saint Paul, Minnesota 55133-3427 (US); FARLEY, Joseph B., Saint Paul, Minnesota 55133-3427 (US); MERCORD, David C., Saint Paul, Minnesota 55133-3427 (US); KAPLAN, Howard M., Saint Paul, Minnesota 55133-3427 (US); RATHORE, Jitendra S., Saint Paul, Minnesota 55133-3427 (US); REDDY, Kevin T., Saint Paul, Minnesota 55133-3427 (US)
(74) Representative: Bergen, Katja
(86) International application number: PCT/IB2023/055242
(87) International publication number: WO 2023/228045

(56) References cited:
- WO-A1-2021/059092
- WO-A1-2021/111279
- US-A1- 2001 046 763
- US-A1- 2012 068 349
- US-A1- 2022 068 771

## Description

### BACKGROUND

Integration of solid semiconductor dies with printing techniques combines the computational prowess of semiconductor technology with the high-throughputs and form-factor flexibility of web-based processes. Flexible hybrid electronics manufacturing requires that semiconductor dies be reliably and accurately registered and connected to printed traces.

Prior art document WO2021/059092 discloses an electronic device including a flexible substrate.

### SUMMARY

A device comprising a flexible substrate is disclosed as recited in claim 1. Further embodiments are recited in the dependent claims.

Briefly, in one aspect, the present disclosure describes a device including a flexible substrate including a first major surface and a second major surface opposite the first major surface. The flexible substrate includes one or more channels and one or more through holes connected by the one or more channels on the first major surface. The device further includes a circuit component attached to the second major surface of the flexible substrate. The circuit component includes one or more contact pads disposed adjacent to an edge of the circuit component. The one or more through holes of the substrate each at least partially overlap with one or more of the contact pads of the circuit component. At least one of the channels extends across the edge of the circuit component and has an inner portion covered by the circuit component, and the inner portion of the at least one channel connects to the at least one through hole at a junction that is indented with respect to the edge.

In another aspect, the present disclosure describes a device including a flexible substrate including a first major surface and a second major surface opposite the first major surface. The flexible substrate includes one or more channels on the first major surface thereof, and one or more through holes connected by the one or more channels on the first major surface. A circuit component is attached to the second major surface of the flexible substrate. The circuit component includes one or more contact pads disposed adjacent to an edge of the circuit component. The one or more through holes of the substrate each at least partially overlap with one or more of the contact pads. The circuit component is positioned with respect to the flexible substrate such that at least one of the channels extends across the edge and connects to at least one of the through holes at a junction which tapers away from the through hole in a plane of the first major surface.

In another aspect, the present disclosure describes a method of making a device not forming part of the claimed invention. The method includes forming one or more channels and one or more through holes connected by the one or more channels on a first major surface of a flexible substrate, and attaching a circuit component to a second major surface of the flexible substrate opposite the first major surface. The circuit component includes one or more contact pads disposed adjacent to an edge of the circuit component. The one or more through holes of the substrate each at least partially overlap with one or more of the contact pads. At least one of the channels extends across the edge and has an inner portion covered by the circuit component, and the inner portion of the at least one channel connects to the at least one through hole at a junction that is indented with respect to the edge.

Various unexpected results and advantages are obtained in exemplary embodiments of the disclosure. One such advantage of exemplary embodiments of the present disclosure is that the sensitive neck region joining electrically conductive traces and vias is located or shaped to protect from possible stretching and bending strain.

Various aspects and advantages of exemplary embodiments of the disclosure have been summarized. The above Summary is not intended to describe each illustrated embodiment or every implementation of the present certain exemplary embodiments of the present disclosure. The Drawings and the Detailed Description that follow more particularly exemplify certain preferred embodiments using the principles disclosed herein.

### BRIEF DESCRIPTION OF THE DRAWINGS

The disclosure may be more completely understood in consideration of the following detailed description of various embodiments of the disclosure in connection with the accompanying figures, in which:
FIG. 1A is a schematic diagram of a process to form an electronic device, according to one embodiment.
FIG. 1B is a cross-sectional view of a portion of the electronic device of FIG. 1A, according to one embodiment.
FIG. 2 is a schematic plan view of an electronic device, according to some embodiments.
FIG. 3 is a schematic diagram of an electronic device, according to some embodiments.
FIG. 4 is a schematic diagram of a channel connected to a via, according to some embodiments.
FIG. 5 is a plot of tensile strain versus radius of curvature for Example 1 and Comparative Example 1.
FIG. 6 is a plot of maximum tensile strain in neck region versus radius of curvature for Example 2 and Comparative Examples 2A and 2B.

In the drawings, like reference numerals indicate like elements. While the above-identified drawing, which may not be drawn to scale, sets forth various embodiments of the present disclosure, other embodiments are also contemplated, as noted in the Detailed Description.

### DETAILED DESCRIPTION

For the following Glossary of defined terms, these definitions shall be applied for the entire application, unless a different definition is provided in the claims or elsewhere in the specification.

The terms "about" or "approximately" with reference to a numerical value or a shape means +/- five percent of the numerical value or property or characteristic, but expressly includes the exact numerical value. For example, a viscosity of "about" 1 Pa-sec refers to a viscosity from 0.95 to 1.05 Pa-sec, but also expressly includes a viscosity of exactly 1 Pa-sec. Similarly, a perimeter that is "substantially square" is intended to describe a geometric shape having four lateral edges in which each lateral edge has a length which is from 95% to 105% of the length of any other lateral edge, but which also includes a geometric shape in which each lateral edge has exactly the same length.

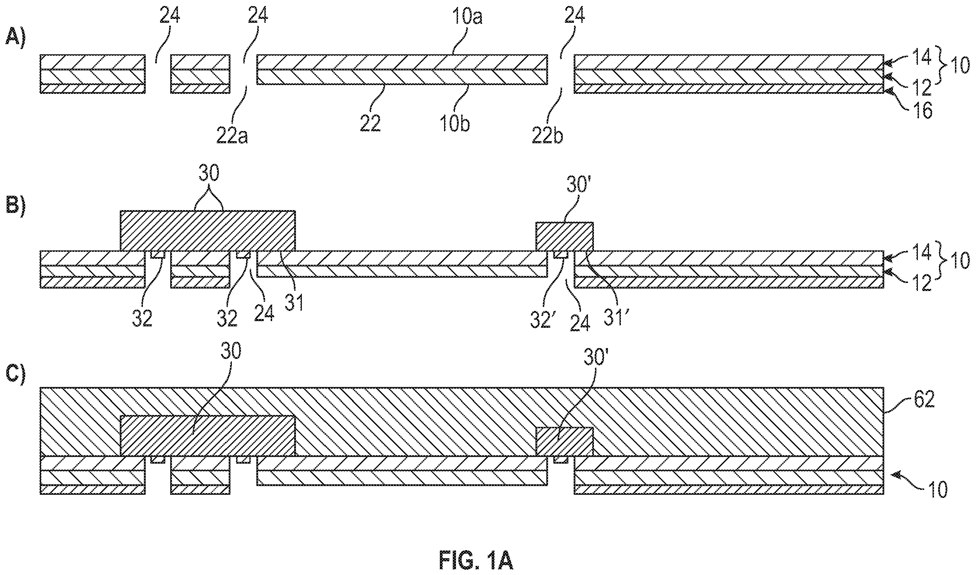

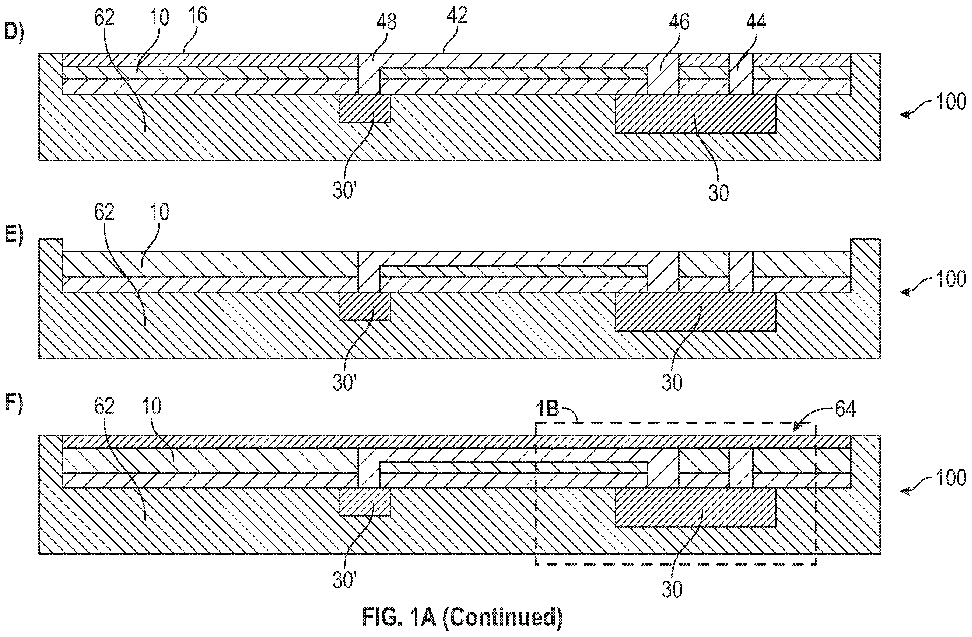

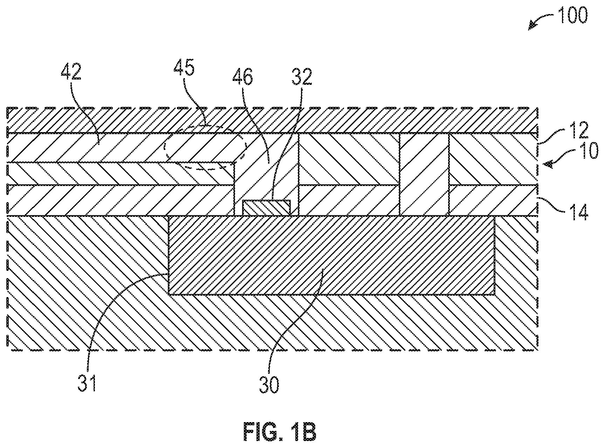

**FIG. 1A** is a schematic diagram of a process to form an electronic device **100,** according to one embodiment. **FIG. 1B** is a plan view of a portion of the electronic device **100.** Referring to Step **(A)** of **FIG. 1A****,** flexible substrate **10** includes a flexible backing layer **12** with an adhesive surface **14** on a first side **10a** thereof. A removable liner **16** is attached to the flexible backing layer **12** on a second side **10b** thereof, opposite the first side **10a.**

In many cases, the flexible substrate **10** may be a portion of a continuous web and the liner **16** is not required to support the flexible substrate **10.** The web may be used in a high-speed, roll-to-roll manufacturing process to electrically connect circuit components including, for example, radio-frequency identification (RFID) tags, near field communication (NFC) circuits, Bluetooth circuits, Wi-Fi circuits, microprocessor chips, bare dies, capacitors, accelerometer chips, and the like, to rapidly produce low-cost circuits for electronic devices.

A pattern of channels **22** is provided on the second side **10b** of the substrate **10.** The channels can be formed by, e.g., cutting completely through the liner **16** and partially into the flexible backing layer **12.** One or more through holes **24** are provided which fluidly connect to one or more of the channels 22. The through holes **24** can be formed by, e.g., cutting completely through the liner **16,** the adhesive **14,** and the flexible backing layer **12.** For example, in the embodiment depicted in **FIG. 1A****,** two through holes **24** are provided to fluidly connect to the ends **22a** and **22b** of the channel **22.** The through holes each extend through the flexible substrate **10** between the first and second sides **10a** and **10b.**

In various embodiments, the channels may have a minimum dimension (e.g., any of length or width / thickness) of, for example, 500 micrometers or less, 300 micrometers or less, 100 micrometers or less, 50 micrometers or less, or 10 micrometers or less. One exemplary channel may have a width of about 50 to about 500 micrometers, and a depth of about 10 to 200 micrometers. In some embodiments, the through holes may have a minimum dimension comparable to that of the channels. One exemplary through hole may have a diameter of about 50 to about 1000 micrometers, about 100 to about 1000 micrometers, or about 300 to about 700 micrometers. In some embodiments, the depth of a through hole may be less than its diameter to extend through the substrate. In some embodiments, a through hole may have a semi-cone shape, which may be resulted from a laser cutting.

The channels and the through holes may be formed in the flexible substrate by any suitable technique such as, for example, chemical etching, laser etching or drilling, mechanical punching, casting against a microstructured metal or polymeric tool, etc. While one arrangement of channels is shown in the embodiment of **FIG. 1A****,** it is to be understood that any other number of channels can be formed on the flexible substrate and the channels can be fluidly connected in various configurations.

The flexible backing layer can include any flexible material such as, for example, polyurethane, rubber, epoxy, polyethylene terephthalate (PET), polyethylene, polystyrene, silicone elastomer (e.g., PDMS), etc. In one example prepared in this disclosure, a polyurethane film was used as a flexible substrate, which is commercially available from 3M Company St. Paul, MN, under the trade designation of COTRAN 9701. It is to be understood that in some embodiments, a portion of the flexible backing layer may be rigid, while the flexible backing layer as a whole can be flexible. The flexible backing layer may be elastic, having a modulus in the range, for example, between 0.1 MPa to 10 GPa.

The adhesive surface can include any suitable adhesive materials to adhesively bond a solid circuit component onto the flexible backing layer. In general, an adhesive material used herein can provide an adhesion strong enough such that the dies may not be easily displaced from their original position during subsequent handling without significantly damaging the backing layer. The adhesive material may also be capable of maintaining its structure, e.g., not reflowing into an adjacent through hole or channel. Exemplary adhesives may include pressure sensitive adhesive (PSA), structural adhesives, acrylic adhesives, epoxy adhesive, urethane adhesives, optical adhesives, silicone-based adhesives, etc.

Referring to Step **(B)** of **FIG. 1A****,** one or more rigid circuitry or circuit components can be provided to attach to the adhesive surface **14** of the flexible substrate **10.** Each circuitry or circuit component has a major surface thereof that can be attached (e.g., adhesively bonded) to the adhesive surface **14.** In **FIG. 1A****,** solid circuit components **30** and **30'** have their respective major surfaces being adhesively bonded to the adhesive surface of the flexible substrate. The solid circuit components **30** and **30'** each include one or more contact pads (e.g., contact pads 32 and 32') on the respective major surfaces **31** and **31'.** The solid circuit components are aligned with respect to the flexible substrate such that the contact pads **32** and **32'** at least partially overlie the corresponding through holes **24.** In **FIG. 1A****,** the solid circuit components **30** and **30'** each have one of its contact pads being received by the corresponding through holes **24** which are fluidly connect to the ends of the channel. It is to be noted that while **FIG. 1A** depicts the contact pads extending out from the surface of the circuit components, this depiction is for illustrative purposes only and there are no limitations on the height of the contact pad relative to the adhesive surface.

Circuitry or circuit components described herein can include one or more circuitry chips having certain circuitry function(s). The circuitry chip may include an array of contact pads arranged along a chip edge on a major surface thereof. In some embodiments, a circuitry chip may include a solid circuit die, a rigid semiconductor die, a printed circuit board (PCB), a flexible printed circuit (FPC), an ultra-thin chip, a radio frequency identification device (RFID), a near field communication (NFC) module, surface-mount devices, batteries, sensors, etc. In some embodiments, a solid circuitry chip can be an ultra-thin chip with a thickness of about 2 micrometers to about 200 micrometers, about 5 micrometers to about 100 micrometers, or about 10 micrometers to about 100 micrometers. It is to be understood that a solid circuitry chip described herein can include any suitable circuits to be disposed on a substrate. In some embodiments, one or more contact pads of a solid circuitry chip or the solid circuitry chip itself can be registered and connected to electrically conductive traces on a substrate.

Referring to Step **(C)** in **FIG. 1A****,** an encapsulating layer **62** is provided onto the first side of the flexible substrate **10** to cover at least a portion of the flexible substrate and encapsulate the solid circuit components **30** and **30'** attached thereon. The encapsulating layer can be formed by applying a liquid encapsulant material. In some cases, the liquid encapsulant material may include, for example, a dielectric material, a polymeric material, and the like. Examples of suitable liquid encapsulant materials include, for example, polyurethane, epoxy, polythiolene, acrylates including urethane acrylates, silicones, and polydimethylsiloxane (PDMS).

With the solid circuit components (e.g., a circuitry chip) secured in position, electrically conductive traces and vias can be formed in the channels and the through holes, respectively. In some embodiments, the electrically conductive traces and vias can be formed by providing a conductive particle-containing liquid in the channels and the through holes. The conductive particle-containing liquid can include any electrically conductive liquid composition containing conductive particles that is flowable, or can be made to flow, in the channels. In some cases, the conductive particle-containing liquid can be formulated to allow flow along the channels primarily by a capillary force. In some cases, the conductive particle-containing liquid can be made to flow int the channels using forces in addition to capillary force, such as for example mechanical pressure provided by a roller or wiping blade. The conductive particle-containing liquid can be cured, hardened or solidified by removing at least portion of the liquid carrier to leave a continuous layer of electrically conductive material that forms electrically conductive traces and vias in the channels and the through holes.

Referring to Step **(D)** of **FIG. 1A****,** the electrically conductive channel traces **42** are formed in the channels and the electrically conductive vias **44, 46** and **48** are formed in the through holes. The formed electrically conductive channel traces **42** can electrically connect a contact pad of a circuit component (e.g., a contact pad of the circuit component **30)** to a contact pad of another circuit component (e.g., a contact pad of the circuit component **30').** The electrically conductive via **46** connects to a contact pad of the circuit component **30.** The electrically conductive via **48** connects to a contact pad of the circuit component **30'.** The electrically conductive channel trace **42** connects to the vias **46** and **48** at its respective ends. The liner **16** on the flexible substrate **10** can protect the flexible substrate from contamination.

Referring to Step **(E),** the liner can be removed from the flexible substrate **10** before or after the formation of the electrically conductive channel traces and vias.

Referring to Step **(F),** an overcoat layer **64** may then be applied to cover the second side of the flexible substrate **10** to protect the underneath traces and vias. The overcoat layer can include any suitable materials such as, for example, polyurethane, epoxy, acrylates including urethane acrylates, silicones, polydimethylsiloxane (PDMS), etc. The overcoat layer may include the same material as the encapsulating layer or may include different materials from the encapsulating layer.

**FIG. 1B** is a cross-sectional view of a portion of the electronic device **100** prepared by the methods illustrated in **FIG. 1A****,** although other methods may be used in its construction. The circuit component **30** is attached to the flexible substrate **10** by adhesive surface **14** opposite flexible backing layer **12.** The circuit component inlcudes contact pad **32** connecting to the via **46** formed in a through hole of the flexible substrate. The electrically conductive via **46** connects to the electrically conductive trace **42** to form an electrical joint at a neck region **45.** A neck region described herein refers to a junction connecting an electrically conductive trace and an electrically conductive via. In some embodiments, a neck region may include a portion of a trace in a channel that joins a via in a through-hole of the substrate and a portion of the via that connects to the trace.

In some embodiments, a neck region may taper gradually from the width of a via to the width of a trace connected to the via. In some embodiments, a neck region may abruptly jump from the via width to the trace width. The overall length of a neck region may broadly depend on its shape, for example, about 0.1 mm to about 5 mm when measured in a length direction of the channel which receives the trace. In some embodiments, a via may connect to multiple traces at multiple neck regions. For example, a via in a through hole may have two (or more) channels coming out from it, in which two (or more) distinct traces connect to the via at the respective neck regions.

It was found in this disclosure that when the neck region extends across or is located adjacent to an edge of a rigid circuit component, e.g., a chip edge, a weak point in the electrical joint performance is near the neck region. The neck region has been shown to be particularly weak during bending and/or stretching of the flexible substrate. For example, upon bending or stretching, a crack (or cracks) may develop in the traces at the neck region well before any other cracks in other locations of the traces are shown. While not wanting to be bound by theory, it is believed that the change in topography of the electrical conductor when transitioning from the deeper via in the through hole to the shallower trace in the channel is part of the reason that the neck region is particularly vulnerable to cracking or breaking.

In the configuration shown in **FIG. 1B****,** the sensitive neck region **45** extends across the edge **31** or lies adjacent to the edge **31** of the rigid component **30,** joining the area from the rigid component **30** to the flexible and stretchable substrate **10.** The present disclosure provides various designs and layouts of an electronic device whereby the neck regions are moved away from the edge of the rigid component. Generally, the electrically conductive traces are routed over an internal area of the substrate which is covered by the rigid component such that the sensitive neck region can be protected from stretch and flex strain by the rigid component beneath.

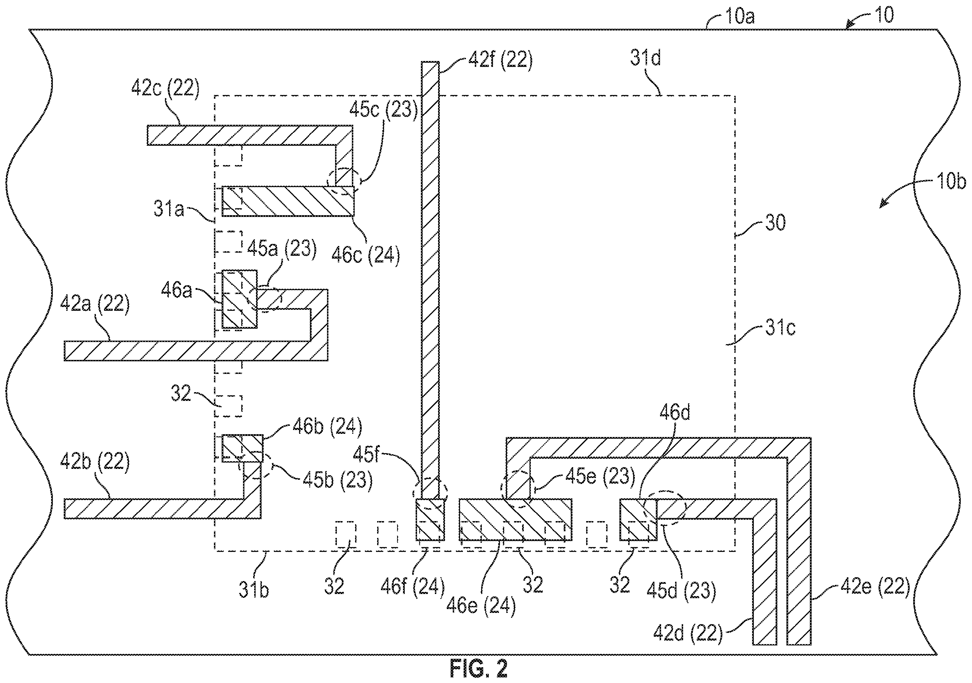

**FIG. 2** is a plan view of a portion of an electronic device where various configurations are provided to protect the neck region joining a trace and a via of the electronic device. Such devices may be prepared by, e.g., the methods illustrated in **FIG. 1A****;** however, any suitable methods may be used. The circuit component **30** is attached to one side of a flexible substrate (e.g., the bottom side **10a** of the flexible substrate **10** as depicted in **FIG. 2****).** The circuit component **30** includes the arrays of electrical contact pads **32** disposed on edges **31a** and **31b.** Generally, electrical contact pads may be provided on any one or more of the edges **31a, 31b, 31c,** and **31d** of the circuit component **30.**

Electrically conductive traces **42a, 42b, 42c, 42d, 42e,** and **42f** are formed in the respective channels **22** on the top side **10b** of the flexible substrate **10,** as depicted in **FIG. 2****.** Electrically conductive vias **46a, 46b, 46c, 46d, 46e, 46f** are formed in the respective through holes **24,** and connect to the respective traces **42a to 42f** to form electrical joints at the respective neck regions **45a, 45b, 45c, 45d, 45e,** and **45f.** The electrical joints are located at the junctions joining the respective channels and the through holes. The vias connect to one or more contact pads **32** of the circuit component **30,** respectively. It is to be understood that any numbers of vias can connect to any numbers of electrical contact pads of a circuit component.

Referring again to **FIG. 2****,** to access to the contact pads **32** on the edge of the circuit component **30,** the electrically conductive traces **42** extend across at least one edge of the circuit component **30** and are routed over an internal area of the substrate which is covered by the circuit component **30.** For example, as depicted in **FIG. 2****,** the traces **42a, 42b,** and **42c** extend across edge **31a;** traces **42d** and **42e** extend across edge **31c;** and trace **42f** extends across the edge **31d** of the circuit component **30.** It is to be understood that the traces formed in the channels can cross over some contact pads on the circuit component without making any electrical connections to the contact pads. This makes routing channels internal to the circuit component possible and easy to achieve.

As depicted in **FIG. 2****,** the electrically conductive traces **42a-42f** and the connected vias **46a-46f** are arranged such that the neck regions **45a-45f** are moved away or indented from the edges of the rigid circuit component **30** where the respective contact pads **32** are located. For example, the trace **42a** extends across the edge **31a** and overlays a portion of the circuit component to access the via **46a** which connects to the contact pads **32** located at the edge **31a.** The inner portion of the trace overlaying the circuit component **30** has a first end starting at the edge **31a** and a second end ending at the junction **23.** The inner portion of the trace **42a** has a "U" shape such that the neck region **45a** is connected to an inner side of the via **46a.**

Similarly, the trace **42b** extends across the edge **31a** to access the via **46b** which connects to the contact pads located at the edge **31a.** The inner portion of the trace **42b** overlaying the circuit component has an "L" shape such that the neck region **45b** is connected to an inner side of the via **46b.** It is to be understood that the inner portion of a trace may have any suitable shapes other than a "U" shape and an "L" shape as long as the inner portion of the trace connects to a via at a junction that is indented with respect to the circuit edge, e.g., being on an inner side of the via with respect to the circuit edge.

The trace **42c** extends across the edge **31a** to access the via **46c** which connects to the contact pads located at the edge **31a.** The electrically conductive via **46c** extends away from the edge **31a** and toward an inner area of the circuit component **30.** The trace **42c** has an inner portion covered by the circuit component **30** beginning at a first end at the edge **31a** and ending at a second end at the junction **23.** The via **46c** (and the through hole **24** where the via **46c** is formed) has a length along the direction substantially perpendicular to the edge **31a** that is sufficiently long such that the neck region **45c** is indented in from the edge **31a.** In some embodiments, the electrically conductive via may have a length, for example, at least 2 times, at least 5 times, or at least 10 times greater than the length of the contact pad of the circuit component.

In some embodiments, an electrically conductive trace may access the contact pads of a circuit component from sides other than the chip edge where the contact pads are located. For example, as depicted in **FIG. 2****,** the traces **42d** and **42e** each extend across the edge **31c** to access to the respective vias **46d** and **46e** which connect to the respective contact pads **32** located at the edge **31b.** The trace **42f** extends across the edge **31d** to access to the corresponding via **46f** which connects to the corresponding contact pad **32** located at the edge **31b** which is opposite the edge **31d.**

As depicted in **FIG. 2****,** the electrically conductive traces are connected to an inner side of the respective vias such that the neck regions **(45a - 45f)** are indented from the respective edges where the respective contact pads are located to protect the neck regions from possible stretch and flex strain of the flexible substrate by the rigid circuit component.

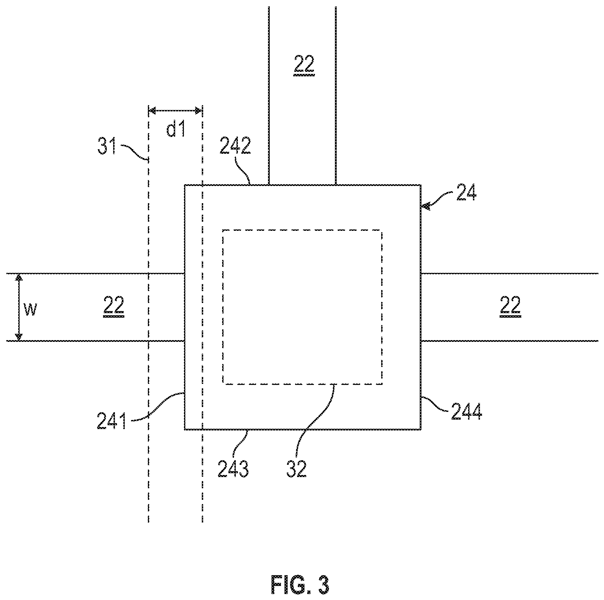

**FIG. 3** further illustrates how a channel connects to various sides of a through hole (and a via formed therein), according to some embodiments. As shown in **FIG. 3****,** the though hole **24** at least partially covers the contact pad **32** of a circuit component underneath. The channel **22** can connect to the through hole **24** from various sides and electrically conductive traces and vias can be formed therein. When the channel **22** connects to the outer side **241** (i.e., the side immediately adjacent to the chip edge **31)** of the through hole **24,** the subsequently formed electrically conductive trace will have its neck region extends across the chip edge **31,** which is a weak point subject to possible stretch and strain of the flexible substrate.

In contrast, when the channel **22** connects to an indented side **242, 243** or **244** of the through hole **24** (i.e., a side not immediately adjacent to the chip edge **31),** the subsequently formed electrically conductive trace has its neck region indented from the chip edge **31.** In some cases, this disclosure provides various configurations where the neck region is indented with respect to the edge **31** and away from a high stress zone which is an inner boundary on the inside perimeter of the chip edge **31.** Such a high-stress zone may have a distance **d1,** for example, comparable to the channel width **w.**

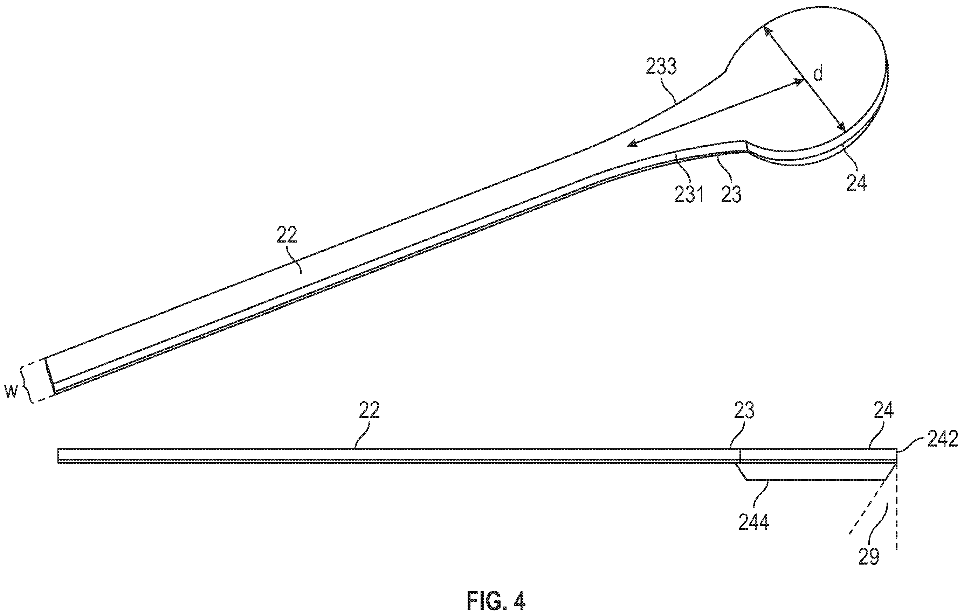

It is to be understood that channels and vias of a substrate may have various shapes and sizes. For example, as depicted in the two views of **FIG. 4****,** the channel **22** connects to the through hole **24** at a junction **23.** The through hole **24** has an upper portion **242** which can be taken as an extension of the channel **22** with substantially the same depth. A lower portion **244** of the through hole **24** vertically connects to the upper portion **242.** In the depicted embodiment, the lower portion **244** has a conical shape with a draft angle **29** which can be negative, zero, or positive with an absolute value, for example, no greater than about 45 degrees, no greater than about 30 degrees, no greater than about 15 degrees, or no greater than about 10 degrees. In various embodiments, the upper portion **242** of the through hole **24** may have a lateral dimension **d,** for example, at least 1.2 times, at least 1.5 times, at least 2 times, or at least 3 times greater than a width w of the channel **22** before the channel **22** approaches the junction **23.** The channel width gradually and smoothly increases at the junction to match at least 30%, at least 50%, at least 70%, or at least 90% of the lateral dimension of the through hole. It was found in this disclosure that when the neck region or junction extends across a chip edge or is located adjacent to the chip edge, the strain experienced by the electrically conductive trace in the sensitive neck region is significantly lower when the trace in the channel has a gradually and smoothly widened end connecting to the corresponding via.

In some cases, such as those depicted in **FIG. 4****,** the neck region at the junction **23** has a teardrop shape. It is to be understood that the neck region may have other suitable shapes. In some cases, the trace has a gradually and smoothly widened end connecting to the via to prevent cracks in the neck region upon bending or stretching of the device. Here the term "smoothly" or "smooth" refers to a geometrical shape of the side surface **231** or **233** of the channel **22** at the junction **23.** The side surface **231** or **233** is substantially smooth when it does not have singular points, in other words, when it has a (unique) tangent plane at substantially every point. The side surface **231** or **233** may have any desired curvatures. The term "gradually" or "gradual" refers to the widening of the channel at the junction **23** when approaching the through hole **24.** The gradient of the gradual widening may be represented by a ratio R=[(d-W)/2]/L, where **d** is the lateral dimension of the upper portion **242** of the through hole **24,** W is the width of the channel adjacent to the junction **23,** and L is the length of the junction **23.** In some embodiments, the ratio **R** may be in a range, for example, from 0.1 to 10, or from 0.1 to 1. It is to be understood that the ratio **R** can be any desired values as long as the channel end smoothly tapers away from the through hole.

The operation of the present disclosure will be further described with regard to the following detailed examples. These examples are offered to further illustrate the various specific and preferred embodiments and techniques. It should be understood, however, that many variations and modifications may be made while remaining within the scope of the present disclosure as defined by the appended claims.

### EXAMPLES

### Summary of Materials

Unless otherwise noted, all parts, percentages, ratios, etc. in the Examples and the rest of the specification are by weight.

**Table 1: Summary of materials used in the Examples.**

| **Description** | **Source** |
|---|---|
| Polyurethane film with a PET liner available under the trade designation COTRAN 9701 | 3M Company, St. Paul, Minnesota USA |
| a strong, stretchable, clear adhesive made from acrylic foam. It has an elasticity modulus of about 1.8 MPa, available under the trade designation VHB Tape 4910 | 3M Company, St. Paul, Minnesota USA |
| a silver flake ink that becomes conductive after solidification, available under the trade designation 127-07. | Creative Materials Inc, Ayer, Massachusetts USA |

### Example 1 and Comparative Example 1

Example 1 and Comparative Example 1 were prepared using a flexible substrate with a layered construction of the adhesive (0.05 mm thick) bonded to the polyurethane film (0.09 mm thick) resulting in a combined thickness of 0.14 mm. A PET liner (0.04 mm thick) was located on the side of the polyurethane film opposite the adhesive. Examples were prepared by drilling with a laser so that the laser cut through the PET liner into the polyurethane film to form a pattern of channels and cut completely through all the layers to form through holes. The laser used to make the channels and through holes was a 400 watt Coherent E400i, CO2 laser, running at a 9.4 micron wavelength. The laser was directed at the PET side of the layered film construction. The partial channels were cut with one pass at marking speed of 1000 mm/s with 100 kHz pulse rate, and about 64 watts of power. The channels formed in the substrate were substantially linear with a generally rectangular or hemispherical cross-section, cut into about 2/3 of the polyurethane layer, and a width of about 160 micrometers. The through holes were cut using a circular path at a marking speed of 1000 mm/sec, 100 kHz pulse rate, and about 28 watts of power with two passes. The through holes formed were semi-cone shaped with a top diameter of about 500 micrometers and a bottom diameter of about 300 micrometers. This resulted in a draft angle of about 35 degrees.

A circuit die (Zero-Drift Amplifier 1 Circuit Rail-to-Rail 8-LFCSP-WD with a manufacturer part number of ADA4528-1ACPZ-R7 from Analog Devices Inc., Norwood, MA. United States) was placed directly on the adhesive surface of the film stack, with its contact pads face down, and then pressed with a force for a few seconds to form a strong adhesive bonding. The channels and through holes were arranged to form contacts to the configuration of the contact pads on the circuit die.

The silver flake ink had a 40% silver loading and was doctor bladed in the pattern of channels and through holes to make contact to the contact pads of the solid circuit die in the through holes. The silver ink was solidified by heating at 98 °C for about 5 to 10 minutes to form electrically conductive traces. The PET liner was removed after the filling of the silver ink.

### Test Methods and Results

The following test methods have been used in evaluating some of the Examples of the present disclosure. Each of samples were bent 500 times in tension mode (ink / chip pad surface flexed out) at approximately 40 mm radius of curvature.

In Example 1an internally-routed trace has a "U" shape and connected to an indented side of the via (i.e., the side of the via opposite the die edge) and the neck region was thus indented away from the edge of the circuit die. The conductive ink remained intact when using this internally routed channel. When the sensitive junction between via and partial channel was indented from the circuit edge, no visible cracks were seen at the neck region. The conductive ink also remained intact where it extended across the underneath circuit edge in the continuous partial channel. Even though the edge of the chip has high strains upon flexing, the ink remained intact. This supports the theory that the neck region is more sensitive to stress and therefore ink breakage than the rest of the channel.

In Comparative Example 1, the trace connected to an outer side of the via (i.e., the side of the via adjacent the die edge) and the neck region was at the edge of the circuit die. The conductive ink tended to break or crack at the sensitive neck region in this configuration of channel routing (direct route). When the sensitive junction between via and the channel was close to the circuit edge, cracks formed in the high strain region, i.e., the sensitive neck region.

### Modeling methods

A finite element model of the channel film, rigid circuit component (e.g., chip, SiP, battery), solidified silver ink, and cured encapsulant system built into a flexible device was created. Models for various samples with a single channel and a via connecting it to a chip were simulated. A commercial finite element analysis software, ANSYS Mechanical APDL 17.1 (Ansys Inc., Pittsburgh PA, USA) was used to create mathematical models of the device with solid187 tetrahedral elements with nonlinear material capabilities to calculate principal tensile strains (EPTO1 in Ansys terminology) in silver ink. Some of modeling inputs are listed in Table 2 along with the design parameters.

**Table 2: Modelling inputs and design parameters.**

| | **Modulus (MPa)** | **Thickness (mm)** |
|---|---|---|
| Silver encapsulant JR7 | 0.36 | 0.051 |
| Channel film TPU | 1600 | 0.076 |
| Silver ink CM 125-13 | 214 | 0.012 |
| Mounting adhesive 91022 | 1.5 | 0.051 |
| SiP | 127,000 | 1.0 |
| SiP encapsulant JR7 | 0.36 | 2.4 |

The FEA model uses an experimental 3-point bending test set-up. Symmetry conditions were used to reduce the model to 1/4th of the device size 30.8×12.25×2.6 mm³. Bending was enabled by two rigid cylinders representing a mandrel of 2.54 cm (1 inch) radius which moves up or down to put a channel side of the model in tension or compression, and a constraining cylinder of a smaller radius on the other side of the model located close to an end. No friction or adhesion were assumed between the cylinders and the model and no restraints were imposed on the device end. As the mandrel comes into contact with either side of the device and bends it the curvature of the side is changing and radius of curvature changes from infinite for a flat surface to about 20 mm.

### Modeling Results

Simulation or modeling results were created for Example 1 and Comparative Example 1. As For the configuration of direct routed channel in Comparative Example 1, the maximum tensile strain exerted on the trace in the channel is calculated to be located in the via close to the channel-to-via transition region (e.g., the neck region). For the configuration of internally-routed channel in Example 1, the tensile strain in the neck region was significantly reduced.

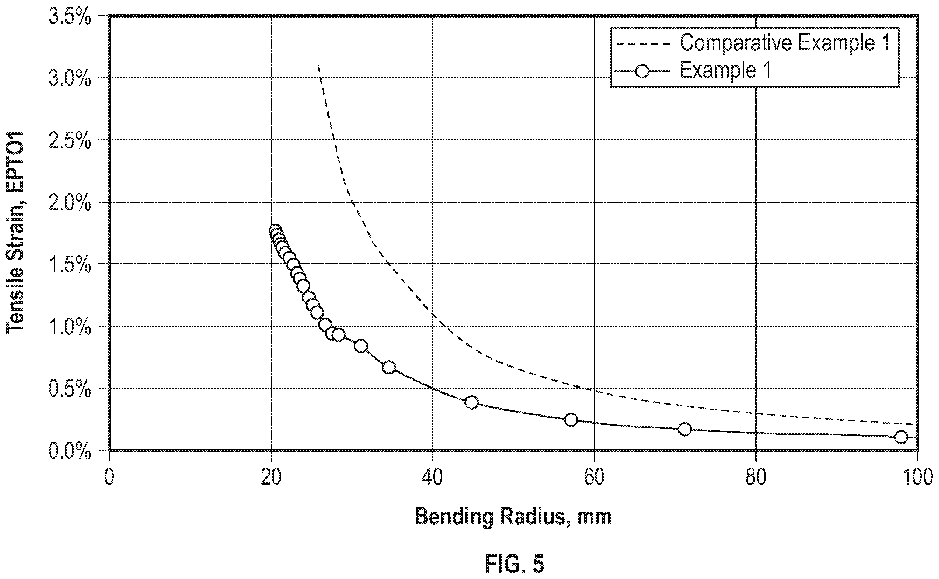

FIG. 5 shows the maximum tensile strain experienced by the trace (e.g., solidified silver ink layer) in the sensitive "neck region" versus radius of curvature of bending. The modelling results of FIG. 5 demonstrate that at the relevant radii of curvature, especially at smaller radii, the strain experienced by the ink in the sensitive neck region of Example 1 is significantly lower than that of Comparative Example 1. Applying the values of the model to the real samples that were made, the strain experienced by the silver ink at about 40 mm radius is about 0.5% with internally routed channels in Example 1 versus 1% for direct routing in Comparative Example 1.

### Example 2 and Comparative Examples 2A and 2B

As modelled, Example 2 had a teardrop-shaped channel at the neck region connected to a through hole. A rectangular channel 200-micrometer wide and 55-micrometer deep was created from the top of the channel film and connected to the through hole. The upper portion of the through hole had a straight side wall with a 1.5 mm diameter. The lower portion of the through hole has a shape of an upturned cone with 1.5 mm top diameter and 45° draft angle. The neck in the shape of teardrop was created by two area fillet of 3 mm radius between a circular concentric channel-deep hole of a slightly smaller diameter and the rectangular channel. The ink depth in the channel is 12 micrometers, and the rest is filled with silver encapsulant JR7.

As modelled, Comparative Example 2A had a straight channel connection (i.e., a uniform dimension of the channel) at the neck region connected to the upper portion of the through hole. As modelled, Comparative Example 2B also has a straight channel connection (i.e., a uniform dimension of the channel) at the neck region but with a channel width equal to the largest width in the neck region in Example 2.

Simulation or modeling results for Example 2 and Comparative Examples 2A and 2B were conducted. The maximum tensile strain exerted on the trace in the channel was calculated to be located in the via close to the channel-to-via transition region (e.g., the neck region).

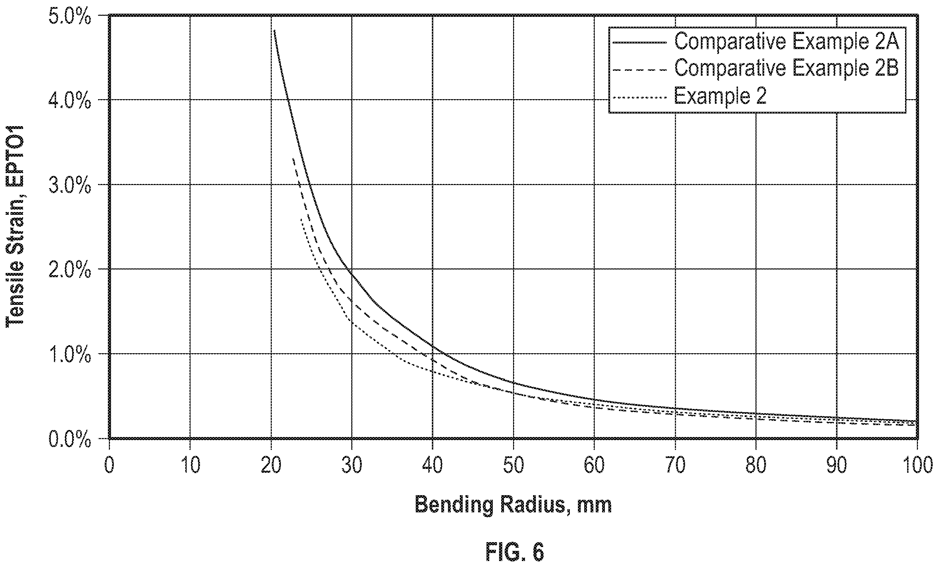

FIG. 6 is a plot of maximum tensile strain in silver ink layer in the sensitive "neck region" versus radius of curvature of bending in tension mode. The modelling results demonstrate that at the relevant radii of curvature, especially at smaller radii, the strain felt by the ink in the sensitive neck region is significantly lower when the channels were teardrop-shaped. Example 2 has lower strain in the neck region as compared to Comparative Examples 2A and 2B.

A series of models both with straight shape (Comparative Example 2A, 2B) and teardrop shape (Example 2) were created in which vias draft angles were varying from 7.9 degrees to 74 degrees. The modeling results showed that vias with draft angles larger than 45 degrees may experience a higher strain in bending. The smallest strains are in vias having draft angles with an absolute value of 45 degrees or smaller.

## Claims

1. A device (100) comprising a flexible substrate (10) including a first side (10a) and a second side (10b) opposite the first side and a circuit component (30) attached to the second side of the flexible substrate, wherein the circuit component is bounded by a plurality of chip edges (31a - 31d) and comprises a first contact pad (32) disposed adjacent to a first chip edge (31a) of the circuit component,
wherein the flexible substrate further comprises a first through hole (24) extending through the flexible substrate and at least partially overlapping the first contact pad; and a first channel (22) on the first side of the flexible substrate wherein the first channel comprises an inner portion of the first channel that connects to the first through hole;
wherein the device further comprises a first electrically conductive via (48) disposed in the first through hole (24) forming a first electrical contact with the first contact pad and a first electrically conductive trace (42) disposed in the first channel (22) and connected to the first electrically conductive via forming a first electrically conductive junction;
**characterized in that** the first channel extends across a second chip edge such that the inner portion of the first channel overlies a portion of the chip, and wherein the first electrically conductive junction connecting the first electrically conductive via (46) to the first electrically conductive trace (42) comprises a neck region (45) that does not cross the first chip edge (31a).

2. The device of claim 1, wherein the first chip edge and the second chip edge are the same edge.

3. The device of claim 1, wherein the first chip edge and the second chip edge are different edges.

4. The device according to any one of the preceding claims, wherein the first channel partially extends into the flexible substrate from the first side.

5. The device according to any one of the preceding claims, wherein the flexible substrate (10) comprises an adhesive layer (14) and the circuit component is attached to the adhesive layer.

6. The device according to claim 5, wherein the flexible substrate is a multilayer structure comprising an adhesive layer and a polymer layer.

7. The device according to any one of the preceding claims, wherein the first electrically conductive junction has a teardrop shape that tapers away from the through hole in a plane of the first side.

8. The device according to any one of the preceding claims, wherein the first through hole has a conical shape with a draft angle of no greater than 45 degrees.

9. The device according to any one of the preceding claims, further comprising a second through hole extending through the flexible substrate and at least partially overlapping a second contact pad of the circuit component, wherein the second contact pad is adjacent to a third chip edge of the circuit component and a second electrically conductive via disposed in the second through hole forming a second electrical contact with the second contact pad.

10. The device of claim 9, wherein the inner portion of the first channel connects to the second through hole and the first electrically conductive trace disposed in the first channel is connected to the second electrically conductive via forming a second electrically conductive junction having a neck region that does not cross the third chip edge.

11. The device of claim 9, further comprising a second channel on the first side of the flexible substrate that extends across a fourth chip edge such that an inner portion of the second channel overlies a portion of the chip, wherein the inner portion of the second channel connects to the second through hole;
wherein the device further comprises a second electrically conductive trace disposed in the second channel and connected to the second electrically conductive via forming a second electrically conductive junction having a neck region that does not cross the third chip edge.

12. The device of claim 10 or 11, wherein the first chip edge and the third chip edge are the same edge.

13. The device of claim 10 or 11, wherein the first chip edge and the third chip edge are different edges.

## Patentansprüche

1. Eine Vorrichtung (100), aufweisend ein flexibles Substrat (10), aufweisend eine erste Seite (10a) und eine der ersten Seite gegenüberliegende zweite Seite (10b), und eine an der zweiten Seite des flexiblen Substrats angebrachte Schaltungskomponente (30), wobei die Schaltungskomponente durch eine Mehrzahl von Chipkanten (31a - 31d) begrenzt ist und eine erste Kontaktfläche (32) aufweist, die angrenzend an eine erste Chipkante (31a) der Schaltungskomponente angeordnet ist,
wobei das flexible Substrat ferner ein erstes Durchgangsloch (24) aufweist, das sich durch das flexible Substrat erstreckt und die erste Kontaktfläche mindestens teilweise überlappt ; und einen ersten Kanal (22) auf der ersten Seite des flexiblen Substrats, wobei der erste Kanal einen inneren Abschnitt des ersten Kanals aufweist, der mit dem ersten Durchgangsloch verbunden ist ;
wobei die Vorrichtung ferner eine erste elektrisch leitfähige Durchkontaktierung (48), die in dem ersten Durchgangsloch (24) angeordnet ist, die einen ersten elektrischen Kontakt mit der ersten Kontaktfläche ausbildet, und eine erste elektrisch leitfähige Spur (42) aufweist, die in dem ersten Kanal (22) angeordnet ist und mit der ersten elektrisch leitfähigen Durchkontaktierung verbunden ist, die einen ersten elektrisch leitfähigen Übergang ausbildet ;
**dadurch gekennzeichnet, dass** der erste Kanal sich über eine zweite Chipkante derart erstreckt, dass der innere Abschnitt des ersten Kanals über einem Abschnitt des Chips liegt, und wobei der erste elektrisch leitfähige Übergang, der die erste elektrisch leitfähige Durchkontaktierung (46) mit der ersten elektrisch leitfähigen Spur (42) verbindet, einen Halsbereich (45) aufweist, der die erste Chipkante (31a) nicht kreuzt.

2. Die Vorrichtung nach Anspruch 1, wobei die erste Chipkante und die zweite Chipkante dieselbe Kante sind.

3. Die Vorrichtung nach Anspruch 1, wobei die erste Chipkante und die zweite Chipkante unterschiedliche Kanten sind.

4. Die Vorrichtung nach einem der vorstehenden Ansprüche, wobei der erste Kanal sich teilweise von der ersten Seite in das flexible Substrat hinein erstreckt.

5. Die Vorrichtung nach einem der vorstehenden Ansprüche, wobei das flexible Substrat (10) eine Klebeschicht (14) aufweist und die Schaltungskomponente an der Klebeschicht angebracht ist.

6. Die Vorrichtung nach Anspruch 5, wobei das flexible Substrat eine Mehrschichtstruktur ist, aufweisend eine Klebeschicht und eine Polymerschicht.

7. Die Vorrichtung nach einem der vorstehenden Ansprüche, wobei der erste elektrisch leitfähige Übergang eine Tropfenform hat, die sich von dem Durchgangsloch weg in einer Ebene der ersten Seite verjüngt.

8. Die Vorrichtung nach einem der vorstehenden Ansprüche, wobei das erste Durchgangsloch eine konische Form mit einem Entformungswinkel von nicht mehr als 45 Grad hat.

9. Die Vorrichtung nach einem der vorstehenden Ansprüche, ferner aufweisend ein zweites Durchgangsloch, das sich durch das flexible Substrat erstreckt und mindestens teilweise eine zweite Kontaktfläche der Schaltungskomponente überlappt, wobei die zweite Kontaktfläche an eine dritte Chipkante der Schaltungskomponente angrenzt und eine zweite elektrisch leitfähige Durchkontaktierung in dem zweiten Durchgangsloch angeordnet ist, das einen zweiten elektrischen Kontakt mit der zweiten Kontaktfläche ausbildet.

10. Die Vorrichtung nach Anspruch 9, wobei der innere Abschnitt des ersten Kanals mit dem zweiten Durchgangsloch verbunden ist und die in dem ersten Kanal angeordnete erste elektrisch leitfähige Spur mit der zweiten elektrisch leitfähigen Durchkontaktierung verbunden ist, wobei ein zweiter elektrisch leitfähiger Übergang ausgebildet wird, der einen Halsbereich hat, der die dritte Chipkante nicht kreuzt.

11. Die Vorrichtung nach Anspruch 9, ferner aufweisend einen zweiten Kanal auf der ersten Seite des flexiblen Substrats, der sich über eine vierte Chipkante derart erstreckt, dass ein innerer Abschnitt des zweiten Kanals über einem Abschnitt des Chips liegt, wobei der innere Abschnitt des zweiten Kanals mit dem zweiten Durchgangsloch verbunden ist ;
wobei die Vorrichtung ferner eine zweite elektrisch leitfähige Spur aufweist, die in dem zweiten Kanal angeordnet und mit der zweiten elektrisch leitfähigen Durchkontaktierung verbunden ist, wobei ein zweiter elektrisch leitfähiger Übergang ausgebildet wird, der einen Halsbereich hat, der die dritte Chipkante nicht kreuzt.

12. Die Vorrichtung nach Anspruch 10 oder 11, wobei die erste Chipkante und die dritte Chipkante dieselbe Kante sind.

13. Die Vorrichtung nach Anspruch 10 oder 11, wobei die erste Chipkante und die dritte Chipkante unterschiedliche Kanten sind.

## Revendications

1. Dispositif (100) comprenant un substrat souple (10) y compris une première face (10a) et une seconde face (10b) opposée à la première face et un composant de circuit (30) fixé à la seconde face du substrat souple, dans lequel le composant de circuit est délimité par une pluralité de bords de puce (31a - 31d) et comprend un premier tampon de contact (32) disposé de manière adjacente à un premier bord de puce (31a) du composant de circuit,
dans lequel le substrat souple comprend en outre un premier trou traversant (24) qui s'étend à travers le substrat souple et qui recouvre au moins partiellement le premier tampon de contact ; et un premier canal (22) sur la première face du substrat souple dans lequel le premier canal comprend une partie intérieure du premier canal qui se connecte au premier trou de passage ;
dans lequel le dispositif comprend en outre un premier via électriquement conducteur (48) disposé dans le premier trou traversant (24) formant un premier contact électrique avec le premier tampon de contact et une première trace électriquement conductrice (42) disposée dans le premier canal (22) et connectée au premier via électriquement conducteur formant une première jonction électriquement conductrice ;
**caractérisé en ce que** le premier canal s'étend sur un deuxième bord de la puce de sorte que la partie intérieure du premier canal recouvre une partie de la puce, et dans lequel la première jonction électriquement conductrice connectant le premier via électriquement conducteur (46) à la première trace électriquement conductrice (42) comprend une région de col (45) qui ne traverse pas le premier bord de la puce (31a).

2. Dispositif selon la revendication 1, dans lequel le premier bord de puce et le deuxième bord de puce sont le même bord.

3. Dispositif selon la revendication 1, dans lequel le premier bord de puce et le deuxième bord de puce sont des bords différents.

4. Dispositif selon l'une quelconque des revendications précédentes, dans lequel le premier canal s'étend partiellement dans le substrat flexible depuis le premier côté.

5. Dispositif selon l'une quelconque des revendications précédentes, dans lequel le substrat souple (10) comprend une couche adhésive (14) et le composant de circuit est fixé à la couche adhésive.

6. Dispositif selon la revendication 5, dans lequel le substrat souple est une structure multicouche comprenant une couche adhésive et une couche de polymère.

7. Dispositif selon l'une quelconque des revendications précédentes, dans lequel la première jonction conductrice d'électricité a une forme de goutte d'eau qui se rétrécit à partir du trou traversant dans un plan du premier côté.

8. Dispositif selon l'une quelconque des revendications précédentes, dans lequel le premier trou traversant a une forme conique avec un angle de dépouille ne dépassant pas 45 degrés.

9. Dispositif selon l'une quelconque des revendications précédentes, comprenant en outre un second trou traversant s'étendant à travers le substrat souple et chevauchant au moins partiellement un second tampon de contact du composant de circuit, dans lequel le second tampon de contact est adjacent à un troisième bord de puce du composant de circuit et un second via électriquement conducteur disposé dans le second trou traversant formant un second contact électrique avec le second tampon de contact.

10. Dispositif selon la revendication 9, dans lequel la partie intérieure du premier canal se connecte au second trou traversant et la première trace conductrice d'électricité disposée dans le premier canal est connectée au second via conducteur d'électricité formant une seconde jonction conductrice d'électricité ayant une région de col qui ne traverse pas le troisième bord de puce.

11. Dispositif selon la revendication 9, comprenant en outre un second canal sur le premier côté du substrat souple qui s'étend sur un quatrième bord de puce de telle sorte qu'une partie intérieure du second canal recouvre une partie de la puce, dans lequel la partie intérieure du second canal se connecte au second trou traversant ;
dans lequel le dispositif comprend en outre une seconde trace conductrice d'électricité disposée dans le second canal et connectée au second via conducteur d'électricité formant une seconde jonction conductrice d'électricité ayant une région de col qui ne traverse pas le troisième bord de puce.

12. Dispositif selon la revendication 10 ou 11, dans lequel le premier bord de puce et le troisième bord de puce sont le même bord.

13. Dispositif selon la revendication 10 ou 11, dans lequel le premier bord de puce et le troisième bord de puce sont des bords différents.
